Europäisches Patentamt

European Patent Office

Office européen des brevets

(11) Veröffentlichungsnummer: **0 123 706**
A2

(12) **EUROPÄISCHE PATENTANMELDUNG**

(21) Anmeldenummer: **83104247.8**

(51) Int. Cl.³: **H 03 H 7/38,** H 03 H 7/19

(22) Anmeldetag: **30.04.83**

(43) Veröffentlichungstag der Anmeldung: **07.11.84 Patentblatt 84/45**

(84) Benannte Vertragsstaaten: **DE FR GB NL**

(71) Anmelder: **ANT Nachrichtentechnik GmbH, Gerberstrasse 33, D-7150 Backnang (DE)**

(72) Erfinder: **Schlotterbeck, Willi, Dipl.-Ing., Häfnersweg 66/1, D-7150 Backnang (DE)**

(74) Vertreter: **Schickle, Gerhard, Dipl.-Ing., ANT Nachrichtentechnik GmbH Patent- und Lizenzabteilung Gerberstrasse 33, D-7150 Backnang (DE)**

(54) **Elektronisch regelbares Laufzeitglied.**

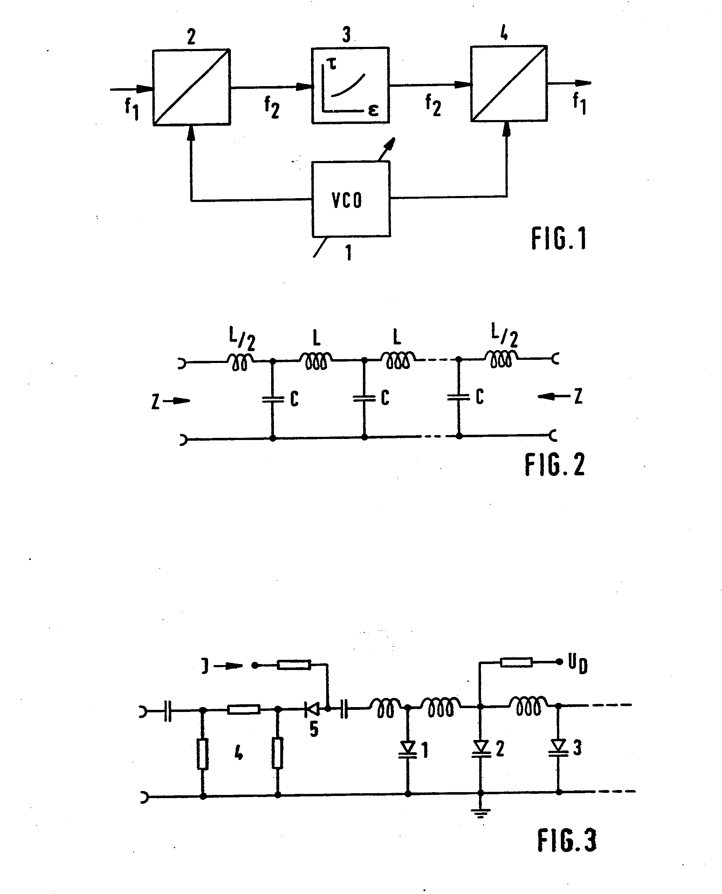

(57) Die Erfindung betrifft ein elektronisch regelbares Laufzeitglied. Dieses ist aus L-C-Gliedern aufgebaut, deren Querkapazitäten durch Kapazitätsdioden realisiert sind (Fig. 3). Eine gleichsinnige Änderung der Vorspannung $U_D$ aller Kapazitätsdioden bewirkt eine entsprechende Änderung der Signallaufzeit, während gleichzeitig ebenfalls von $U_D$ gesteuerte Anpaßglieder den wellenwiderstandsrichtigen Abschluß des Laufzeitgliedes am Ein- und Ausgang sicherstellen und vorgeschaltete ohmsche $\pi$-Glieder die Anpassung der Schaltung an Generator und Last gewährleisten.

## Elektronisch regelbares Laufzeitglied

Um RF- oder ZF-Signale aus Empfängern verschiedener Diversitypfade derselben Troposcatter- oder LOS-Strecke zusammenfassen zu können, bedient man sich sog. Kombinatoren, die zweckmäßigerweise im ZF-Bereich eingesetzt werden. Diese setzen die Signale mit optimalem Signal/Geräuschabstand phasenrichtig (bezogen auf die Phase der ZF-Signale) zusammen, ohne jedoch evtl. vorhandene Laufzeitdifferenzen ausgleichen zu können. Bei Schmalbandanlagen ist dies im allgemeinen auch nicht erforderlich.

Bei Breitbandanlagen oder immmer dann, wenn die Laufzeitdifferenz $\Delta \tau$ in die Größenordnung von $\frac{T}{2}$ kommt (wobei $T = \frac{1}{fm}$ die Periodendauer der höchsten Modulationsfrequenz darstellt) oder diesen Wert überschreitet, ist ein Laufzeitausgleich erforderlich. In Stufen schaltbare Laufzeitglieder (z.B. Leitungsstücke oder "tapped delay lines" kommen hierfür oft nicht in Betracht, da sprunghaftes Schalten vermieden werden muß. Eine mechanisch innerhalb gewisser Grenzen stetig in ihrer Länge veränderliche koaxiale Leitung ist zumindest dann ungeeignet, wenn der Einstellvorgang häufig und schnell z.B. abhängig von wetterbedingten Ausbreitungsbedingungen erfolgen soll. Außerdem erfordern solche Einsatzfälle unhandliche Leitungslängen. Ferner wurde bereits elektronisch einstellbares Laufzeitglied gemäß Fig. 1 intern vorgeschlagen. Es wird dabei mit Hilfe des spannungsgesteuerten Oszillators 1 und des Mischers 2 eine erste Zwischenfrequenz $f_1$ in eine zweite Zwischenfrequenz $f_2$ umgesetzt. Diese passiert ein Reaktanznetzwerk 3 mit frequenzabhängiger Laufzeit. Anschließend erfolgt eine Rückumsetzung in die erste Zwischenfrequenz $f_1$ mittels Mischer 4 und Oszillator 1. Wird nun abhängig von einem geeignet gewählten Regelkriterium die Betriebsfrequenz des spannungsgesteuerten Oszillators verändert, so ändert sich auch $f_2$ und damit die Signallaufzeit im Reaktanznetzwerk 3.

Abgesehen von dem apparativen Aufwand für die doppelte Umsetzung und von den in Fig. 1 nicht gezeichneten Filtern zur Unterdrückung unerwünschter Mischprodukte bleibt als Nachteil dieser Schaltung, daß das Netzwerk 3 zwangsläufig auch Laufzeitverzerrungen erzeugt, die vielfach nachträglich mittels eines Entzerrers ausgeglichen werden müssen.

Ziel vorliegender Erfindung ist es, die zuletzt genannten Nachteile zu vermeiden.

Gelöst wird dies durch die Merkmale im Kennzeichen des Hauptanspruchs.

Eine vorteilhafte Weiterbildung kann gemäß dem Unteranspruch realisiert werden.

Eine homogene Leitung mit dem Induktivitätsbelag L' und dem Kapazitätsbelag C' hat bekanntlich den Wellenwiderstand

$$Z = \sqrt{\frac{L'}{C'}} \tag{1}$$

und die Laufzeit pro Längeneinheit

$$\tau = \sqrt{L' \cdot C'} \tag{2}$$

Eine Nachbildung einer solchen homogenen Leitung aus den konzentrierten Elementen L und C ist in Fig. 2 dargestellt. Für diese Nachbildung gilt entsprechend

$$Z = \sqrt{\frac{L}{C}} \tag{3}$$

und für die Laufzeit eines Halbgliedes

$$\tau = \sqrt{L \cdot C} \tag{4}$$

Die gesamte Laufzeit einer solchen "Laufzeitkette" aus n Bauteilen errechnet sich dann zu

$$\tau_{ges.} = \frac{n-1}{2} \sqrt{L \cdot C} \qquad (5)$$

In der Fig. 3 ist ein gemäß der Erfindung aufgebautes Laufzeitglied schematisch dargestellt. Werden sämtliche Kapazitäten - realisiert durch Kapazitätsdioden 1, 2, 3 - gleichsinnig elektronisch variiert, so ändert sich $\tau_{ges.}$ entsprechend. Diese Maßnahme führt allerdings zu einer gleichzeitigen Änderung des Wellenwiderstandes Z. Diese wird durch an beiden Enden zugeschaltete elektronisch veränderliche Anpassungsglieder kompensiert. Das in Fig. 3 dargestellte Anpassungsglied 4 besteht aus einem aus drei Festwiderständen gebildeten $\pi$-Dämpfungsglied zur Entkopplung von Generator bzw. Last vom Laufzeitglied und pro Anpaßschaltung aus einer einzigen PIN-Diode 5, deren Widerstand über den Strom I abhängig von $U_D$ so verändert wird, daß die Laufzeitkette stets mit dem Wellenwiderstand $Z = \sqrt{\frac{L}{C}}$ abgeschlossen ist. Dabei wird die Diodenvorspannung $U_D$ proportional der störenden Signallaufzeit gewählt, um diese zu kompensieren.

Soll der Ausgangspegel des elektronisch regelbaren Laufzeitgliedes unabhängig vom Regelzustand konstant gehalten werden, läßt es sich in an sich bekannter Weise mit einer automatischen Pegelregelung kombinieren.

- 1 -

ANT Nachrichtentechnik GmbH          K1 E7/Sch/sch
Gerberstr. 33                         BK 83/35
D-7150 Backnang

Patentansprüche

1. Elektronisch regelbares Laufzeitglied für ein breitbandiges Diversity-Empfangssystem, bei dem die empfangenen Signale mit optimalem Signal/Geräuschabstand mittels Kombinatoren phasenrichtig zusammengesetzt werden, <u>dadurch gekennzeichnet,</u> daß zum Laufzeitausgleich von n Diversity-Signalen an mindestens (n-1) Eingängen des Kombinators je ein Laufzeitglied vorgesehen ist, von denen jedes aus L-C-Halbgliedern besteht, deren Querkapazitäten (c) durch Kapazitätsdioden (1, 2, 3, ...) realisiert werden, die mit einer der störenden Laufzeit der Signale proportionalen Spannung ($U_D$) gesteuert werden, und daß abhängig von $U_D$ durch den Strom I gesteuerte PIN-Dioden (5) in Verbindung mit je einem ein- und ausgangsseitigen ohmschen $\pi$-Glied (4) den wellenwiderstandsrichtigen Abschluß des Laufzeitgliedes und gleichzeitige Anpassung der Schaltung an Generator und Last bewirken.

2. Laufzeitglied nach Anspruch 1, <u>dadurch gekennzeichnet,</u> daß sein Ausgangspegel konstant gehalten wird.

FIG.1

FIG.2

FIG.3